# EUROPEAN PATENT APPLICATION

(11) **EP 2 608 273 A2**
(43) Date of publication of application: **26.06.2013**
(21) Application number: 12173319.0
(22) Date of filing: 23.06.2012
(51) Int. Cl.: H01L 31/0336, H01L 31/072

(54) **Solar cell having a pn hetero-junction**

(30) Priority: 23.12.2011 TW 100148322
(71) Applicant: AU Optronics Corporation, Hsin-Chu (TW)
(72) Inventor: Yang, Po-Chuan, Hsin-Chu (TW); Chan, I-Min, Hsin-Chu (TW)
(74) Representative: Lang, Christian

(57) **Abstract**

Disclosed herein is a solar cell, which includes a first conductive layer, a photoelectric conversion layer and a second conductive layer. The photoelectric conversion layer is disposed above the first conductive layer. The photoelectric conversion layer includes a silicon substrate and a CIGS layer that is in contact with the silicon substrate, so that a PN hetero-junction is formed between the silicon substrate and the CIGS layer. The second conductive layer is disposed above the photoelectric conversion layer.

## Description

### RELATED APPLICATIONS

This application claims priority to Taiwan Application Serial Number 100148322, filed December 23, 2011, which is herein incorporated by reference.

### BACKGROUND

### Technical Field

The present disclosure relates to a solar cell having a PN hetero-junction.

### Description of Related Art

Much research attention has been given to solar energy for being a seemingly inexhaustible energy source. Solar cells are devices developed for such purpose by converting solar energy directly into electrical energy.

In recent years, researchers are interested in copper indium gallium selenide (CIGS) solar cells because CIGS films exhibit a high efficiency of photoelectric conversion. In such solar cells, a CIGS film and a N-type semiconductor layer are required to form a PN junction. The CIGS solar cells exhibit the highest efficiency of photoelectric conversion when cadmium sulfide (CdS) is unitized as the N-type semiconductor layer and cooperates with the CIGS film. Unfortunately, CdS material is forbidden in many countries since CdS is a serious pollutant. Accordingly, the application of CIGS solar cells is critically restrained.

In view of the above, there exists in this art a need for an improved solar cell that fulfills the requirements of environmental protection and also provides a high efficiency of photoelectric conversion.

### SUMMARY

The solar cell comprises a first conductive layer, a photoelectric conversion lyer and a second conductive layer. The photoelectric conversion layer is configured to convert light into electricity, and is disposed above the first conductive layer. The photoelectric conversion layer comprises a silicon substrate and a copper indium gallium selenide (CIGS) layer in contact with the silicon substrate, so that the CIGS layer forms a PN hetero-junction with the silicon substrate. The second conductive layer is disposed above the photoelectric conversion layer. The fist conductive layer and the second conductive layer are configured to transmit the electricity.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiments, with reference made to the accompanying drawings as follows:
Fig. 1A is a cross-sectional view schematically illustrating a solar cell according to one embodiment of the present disclosure;
Fig. 1B is a cross-sectional view schematically illustrating a solar cell according to another embodiment of the present disclosure;
Fig.2 is graph showing current density-voltage curves, illustrating a comparison between a conventional CIGS solar cell and a solar cell according to one embodiment of the present disclosure; and
Fig. 3 is graph showing current density-voltage curves of solar cells according to three different embodiments of the present disclosure.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawings.

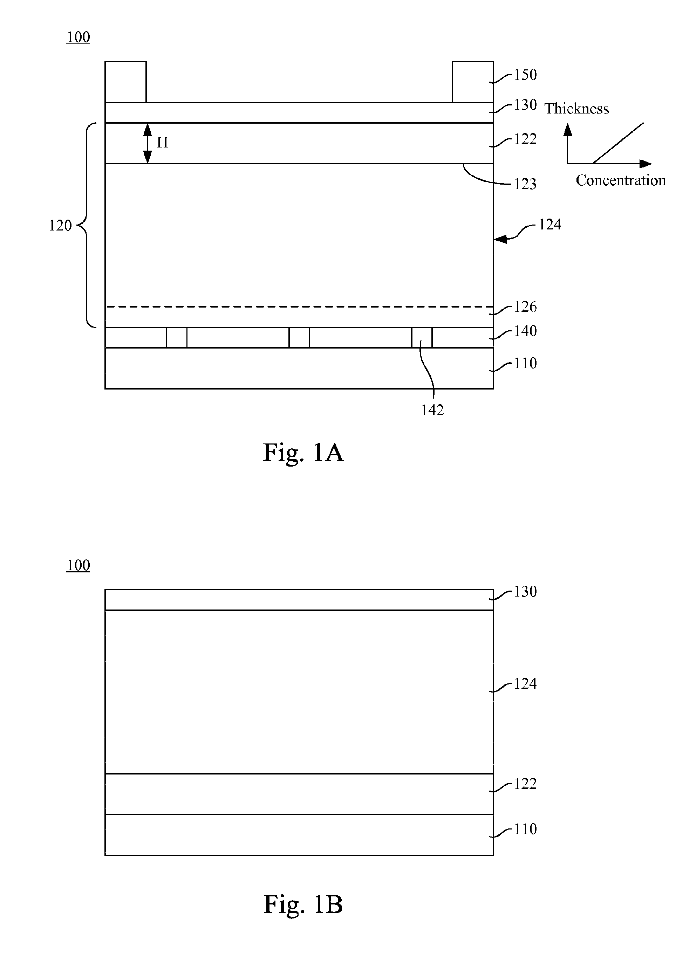

Fig. 1A is a cross-sectional view schematically illustrating a solar cell 100 according to one embodiment of the present disclosure. The solar cell 100 includes a first conductive layer 110, a photoelectric conversion layer 120 and a second conductive layer 130.

The photoelectric conversion layer 120 is positioned between the first conductive layer 110 and the second conductive layer 130, and is electrically connected to the first and second conductive layers 110,130. The photoelectric conversion layer 120 is capable of converting light into electricity, which is transmitted through the first and the second conductive layers 110, 130 to an external loading device (not shown).

The photoelectric conversion layer 120 includes a copper indium gallium selenide (CIGS) layer 122 and a silicon substrate 124. The CIGS layer 122 is in contact with the silicon substrate 124, such that the CIGS layer 122 forms a PN hetero-junction 123 with the silicon substrate 124.

In one embodiment of the present disclosure, the photoelectric conversion layer 120 does not include cadmium sulfide. In the prior art, a cadmium sulfide (CdS) layer is typically formed on the CIGS layer 122 for the purpose of forming a PN junction. However, cadmium sulfide is forbidden in many countries because cadmium sulfide causes a serious pollution problem. Accordingly, the solar cell 100 in one embodiment of the present disclosure may be used and accepted in most countries.

It is a feature of the present disclosure that the CIGS layer 122 is in contact with the silicon substrate 124, and thus forming the PN hetero-junction 123. As compared to conventional CIGS solar cells, the PN hetero-junction 123 formed by the CIGS layer and the silicon substrate leads to a lower reverse saturation current and a higher open-circuit voltage of the solar cell 100. A low reverse saturation current implies that the energy loss due to leakage current of the solar cell may be reduced. Furthermore, a high open-circuit voltage suggests that the photoelectric conversion efficiency of the solar cell may be increased.

The CIGS layer 122 may comprise either P-type CIGS or N-type CIGS. In one embodiment, the CIGS layer 122 comprises P-type CIGS, and the silicon substrate 124 is an N-type silicon substrate. The silicon substrate 124 may include a heavily doped region 126 formed on a surface of the silicon substrate 124 at a side adjacent to the first conductive layer 110. In this embodiment, the heavily doped region 126 is a heavily doped N+ region (N+ region) for increasing the build-in electric field of the solar cell 100. Accordingly, the heavily doped region 126 also refers as "a surface-electric-field layer". In another embodiment, the CIGS layer 122 comprises N-type CIGS, whereas the silicon substrate 124 is a p-type silicon substrate. In this embodiment, the heavily doped region 126 is a heavily doped P+ region, and is formed on a surface of the silicon substrate 124 at a side adjacent to the first conductive layer 110.

The silicon substrate 124 may be a single crystalline silicon wafer, or a composite substrate that comprises a block and at least one of single crystalline silicon layer, polycrystalline silicon layer and amorphous silicon formed on the block. The silicon substrate 124 may be about 100 µ m to about 500 µ m in thickness.

In one embodiment, the CIGS layer 122 has a gallium concentration distribution in a thickness direction of the CIGS layer 122. For example, the CIGS layer 122 has a low gallium concentration at a side that is in contact with the silicon substrate 124. On the other hand, the CIGS layer 122 has a high gallium concentration at a side that is away from the silicon substrate 124, as depicted in Fig. 1A . The inventor of the present disclosure discovers that an increase in gallium concentration may lead to an increase in the open-circuit voltage, but undesirably causes a significant decrease in the temperature coefficient of the solar cell in some examples. That is to say, the photoelectric conversion efficiency of the solar cell is significantly decreased when the temperature of the solar cell is raised. As a result, when the solar cell experiences a variation in temperature, the overall photoelectric conversion efficiency is possibly declined. Therefore, the CIGS layer 122 is intended to have a gallium concentration distribution to mitigate or prevent the temperature influence on the photoelectric conversion efficiency. As a result, according to one embodiment of the present disclosure, the solar cell may exhibit a high efficiency of photoelectric conversion at a room temperature, and further the efficiency may be kept at a high temperature. In examples, the atomic ratio of gallium over the sum of gallium and indium (i.e., Ga/(Ga+ln)) in the CIGS layer 122 is about 0.2 to about 0.9.

Furthermore, both the CIGS layer 122 and the silicon substrate 124 have the photovoltaic effect. When a light transmits through the CIGS layer 122, a portion of the light is absorbed and converted into electricity, while another portion of the light directly passes through the CIGS layer 122 without being absorbed. The portion of the light directly passing through the CIGS layer 122 may reach the silicon substrate 124, and be absorbed and converted into electricity by the silicon substrate 124. Accordingly, the solar cell disclosed herein exhibits an excellent efficiency of photoelectric conversion.

In examples, co-evaporation techniques, sputtering processes, printing processes or other suitable processes may be employed to form the CIGS layer 122 on the silicon substrate 124. In one embodiment, the thickness H of the CIGS layer 122 is about 0.1 µ m to about 5 µ m, specifically about 0.1 µ m to about 2 µ m, more specifically about 0.1 µ m to about 1 µ m. It is noted that the thickness of the CIGS layer is less than that of conventional CIGS solar cells, but still exhibiting a better efficiency of photoelectric conversion than that of conventional CIGS solar cells.

The first conductive layer 110 and the second conductive layer 130 are respectively disposed on opposite sides of the photoelectric conversion layer 120 for the purpose of transmitting the electricity generated by the photoelectric conversion layer 120. Specifically, the photoelectric conversion layer 120 is disposed above the first conductive layer 110, and the second conductive layer 130 is positioned above the photoelectric conversion layer 120. Various physical vapor deposition techniques may be unitized to form the first and second conductive layers 110, 130.

In the embodiment depicted in Fig. 1A , a light is transmitted into the solar cell 100 from the side of the second conductive layer 130. Therefore, the second conductive layer 130 may be a transparent conductive layer made of a material such as indium tin oxide, zinc oxide, tin oxide, zinc magnesium oxide or other conductive oxides. The thickness of the second conductive layer 130 may be about 50nm to about 100 nm, for example. The first conductive layer 110 may be a metal layer made of silver or aluminum, for example.

The CIGS layer 122 may be disposed above or under the silicon substrate 124. In one embodiment, the CIGS layer 122 is positioned between the second conductive layer 130 and the silicon substrate 124, as depicted in Fig. 1A . In another embodiment, as depicted in Fig. 1B, the CIGS layer 122 is positioned between the first conductive layer 110 and the silicon substrate 124. In this embodiment, the light is transmitted into the solar cell 100 from the side of the second conductive layer 130. In examples, the silicon substrate 124 may be in contact with the second conductive layer 130, and the CIGS layer 122 is in contact with first conductive layer 110.

In one embodiment, the solar cell 100 further includes a reflecting layer 140 disposed beneath the photoelectric conversion layer 120, as depicted in Fig. 1A . Specifically, the reflecting layer 140 is positioned between the silicon substrate 124 and the first conductive layer 110, and is configured to reflect the light (i.e., long wavelength light) that directly passes through the photoelectric conversion layer 120. In one example, the reflecting layer 140 is not made of a metallic material. In particular, the reflecting layer 140 may be made of a conductive oxide such as indium tin oxide, indium tungsten oxide, or zinc oxide doped with aluminum or gallium (ZnO:Al or ZnO:Ga). However, the reflecting layer 140 may be made of a non-conductive material such as silicon oxide. When the reflecting layer 140 is made of non-conductive material, the reflecting layer 140 have a number of contact holes 142 such that the first conductive layer 110 may be electrically connected to the photoelectric conversion layer 120 through the contact holes 142.

In another embodiment, the solar cell 100 further includes an auxiliary electrode 150 disposed on the second conductive layer 130, as depicted in Fig. 1A . The auxiliary electrode 150 may be a patterned electrode. For example, the auxiliary electrode150 may be configured as matrix pattern (i.e., a grid pattern). The auxiliary electrode150 may be made of a metal material with high conductivity such as sliver or aluminum.

In still another embodiment, the silicon substrate 124 is in contact with the first conductive layer 110, and the silicon substrate 124 has a heavily doped region with a high doping concentration at the side adjacent to the first conductive layer 110 in order to form a back electric field in the solar cell 100. The heavily doped region may be formed by implantation or diffusion processes. The back electric field is formed between the silicon substrate 124 and the first conductive layer 110.

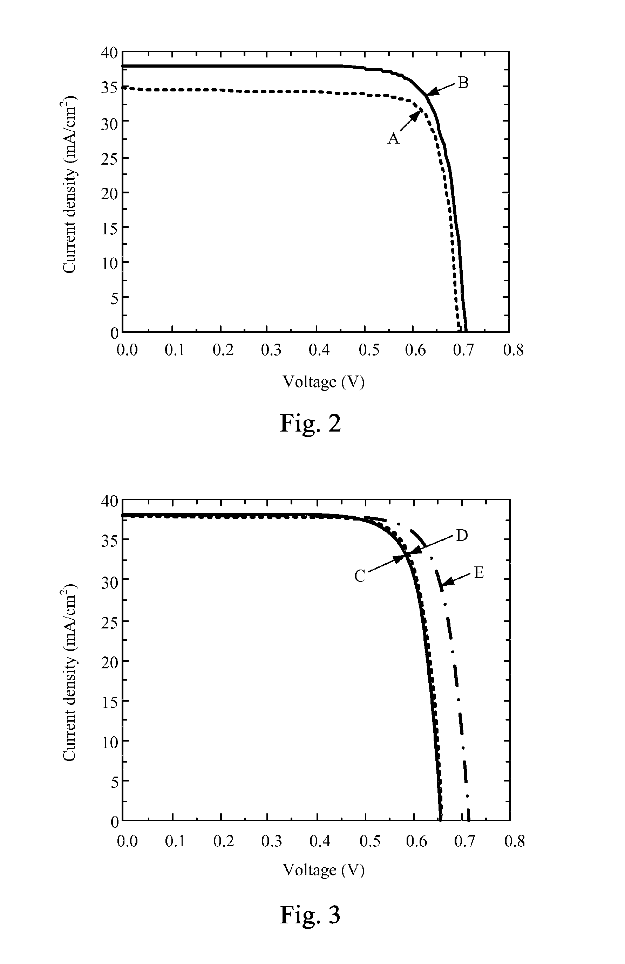

Fig. 2 is graph showing current density-voltage curves of solar cells, illustrating a comparison between a conventional CIGS solar cell and a solar cell according to one embodiment of the present disclosure. In Fig. 2, curve A represents the conventional CIGS solar cell, whereas curve B represents the solar cell according to one embodiment of the present disclosure. Both the open-circuit voltage and the current density of the solar cell according to the present disclosure are higher than that of the conventional CIGS solar cell.

Fig. 3 is graph showing current density-voltage curves of solar cells for three different embodiments of the present disclosure. Curve C represents an embodiment in which the silicon substrate 124 does not includes the heavily doped region 126. Curve D represents an embodiment in which the silicon substrate 124 has the heavily doped region 126. Curve E represents an embodiment in whcih the silicon substrate 124 includes the heavily doped region 126, and also the CIGS layer 122 has a gallium concentration distribution. As shown in Fig. 3, both the open-circuit voltage and the current density associated with the solar cell in connection with curve E (i.e., the CIGS layer with a gallium concentration distribution) are higher than that of the other two embodiments.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims.

## Claims

1. A solar cell (100), comprising:
a first conductive layer (110);
a photoelectric conversion layer (120) for converting light into electricity, the photoelectric conversion layer being disposed above the first conductive layer, wherein the photoelectric conversion layer comprises a silicon substrate (124) and a copper indium gallium selenide layer (122) in contact with the silicon substrate, and the copper indium gallium selenide layer forms a PN hetero-junction (123) with the silicon substrate; and
a second conductive layer (130) disposed above the photoelectric conversion layer, wherein the fist conductive layer and the second conductive layer are configured to transmit the electricity.

2. The solar cell according to claim 1, wherein the first conductive layer and the second conductive layer are respectively a metal layer and a transparent conductive layer, and the copper indium gallium selenide layer is positioned between the transparent conductive layer and the silicon substrate.

3. The solar cell according to claim 1, wherein the copper indium gallium selenide layer comprises P-type copper indium gallium selenide, and the silicon substrate comprises a N-type silicon substrate.

4. The solar cell according to claim 3, wherein the silicon substrate comprises a heavily doped N+ region (126) positioned on a surface adjacent to the first conductive layer.

5. The solar cell according to claim 1, wherein the photoelectric conversion layer does not comprise cadmium sulfide.

6. The solar cell according to claim 1, wherein the copper indium gallium selenide layer comprises N-type copper indium gallium selenide, and the silicon substrate comprises a P-type silicon substrate.

7. The solar cell according to claim 6, wherein the silicon substrate comprises a heavily doped P+ region (126) positioned on a surface adjacent to the first conductive layer.

8. The solar cell according to claim 1, wherein the copper indium gallium selenide layer has a gallium concentration distribution, and a gallium concentration at an end position adjacent to the silicon substrate is less than a gallium concentration at another end position away from the silicon substrate.

9. The solar cell according to claim 1, wherein the copper indium gallium selenide layer has a thickness of about 0.1 µ m to about 5 µ m.

10. The solar cell according to claim 1, wherein the first conductive layer and the second conductive layer are respectively a metal layer and a transparent conductive layer, and the copper indium gallium selenide layer is positioned between the metal layer and the silicon substrate.

11. The solar cell according to claim 1, wherein the copper indium gallium selenide layer has a atomic ratio of gallium over the sum of gallium and indium of about 0.2 to about 0.9.

12. The solar cell according to claim 1, wherein the copper indium gallium selenide layer has a thickness less than a thickness of the silicon substrate.

13. The solar cell according to claim 1, further comprising a reflecting layer (140) disposed between the silicon substrate and the first conductive layer.

14. The solar cell according to claim 13, wherein the reflecting layer comprises a conductive oxide selected from a group consisting of indium tin oxide, indium tungsten oxide, zinc oxide doped with aluminum, and zinc oxide doped with gallium.

15. The solar cell according to claim 13, wherein the reflecting layer is made of a non-conductive material, and the reflecting layer has a plurality of contact holes (142) for electrically connecting the first conductive layer to the photoelectric conversion layer.
